# EUROPEAN PATENT APPLICATION

(11) **EP 2 422 914 A2**
(43) Date of publication of application: **29.02.2012**
(21) Application number: 11177060.8
(22) Date of filing: 10.08.2011
(51) Int. Cl.: B23K 20/00, H01L 21/60

(54) **Capillary and ultrasonic transducer for ultrasonic bonding with adapted flexure rigidity**

(30) Priority: 11.08.2010 JP 2010180198
(71) Applicant: FUJITSU LIMITED, Kawasaki-shi, Kanagawa 211-8588 (JP)
(72) Inventor: Matsumura, Takayoshi, Kanagawa, 211-8588 (JP)
(74) Representative: HOFFMANN EITLE

(57) **Abstract**

A capillary is attached to an ultrasonic transducer (10) of a wire-bonding apparatus. The capillary includes a first part (22Aa) configured to be attached to the ultrasonic transducer (10), and a second part (22Ab) other than the first part (22Aa) and extending from the first part (22Aa). The first part (22Aa) has a shape different from a shape of the second part (22Ab) so that the first part (22Aa) has a flexure rigidity larger than the second part (22Ab).

## Description

### FIELD

The embodiment discussed herein is directed to a capillary and transducer used for an ultrasonic wire-bonding apparatus.

### BACKGROUND

A wire-bonding apparatuses is widely used as an apparatus to electrically connect a semiconductor chip to a wiring board. A typical wire-bonding apparatus uses a system to join a bonding-wire by providing an ultrasonic vibration to a capillary provided on an end of a bonding head.

The bonding head includes a transducer for transmitting an ultrasonic vibration, an ultrasonic vibrator attached to a base part of the transducer, and a capillary attached to an extreme end of the transducer. The capillary is a hollow, elongated cylindrical member so that a bonding-wire is supplied from an upper part of the capillary to the extreme end of the capillary by being passed through inside the capillary. An ultrasonic vibration generated by the ultrasonic vibrator is amplified by the transducer (ultrasonic horn), and is transmitted to the extreme end of the transducer. Accordingly, the entire capillary vibrates transversely due to the ultrasonic vibration at the extreme end of the transducer. The bonding wire can be ultrasonically bonded to an electrode or the like by pressing the bonding wire by a tip of the capillary, which is transversely vibrating as mentioned above.

In recent years, with advance in miniaturization and densification of electrodes of a semiconductor chip to which a bonding wire is bonded, each electrode has become smaller and an interval (pitch) of the electrodes has become extremely narrower. In order to bond a bonding wire to such an electrode, a diameter of a tip of the capillary has become very small. Accordingly, if a tip of the capillary is not ultrasonic-vibrated properly, it is possible that a bonding fault of the bonding wire occurs. The capillary is attached to the extreme end of the transducer so that the entire capillary vibrates in a transverse direction, and, thereby, the bonding wire can be properly bonded by the ultrasonic vibration.

However, because the capillary is extended on one side of the transducer in a direction perpendicular to the direction of an axis of the transducer at the extreme end of the transducer, a vibration (transverse vibration) in a flexural direction may be generated due to the ultrasonic vibration, which is a longitudinal vibration of the transducer. Because the capillary is attached to the transducer to extend perpendicularly with respect to the longitudinal direction of the transducer, if a flexural vibration occurs in the transducer, the capillary may not only vibrate in a transverse direction but also in an axial direction (longitudinal direction) of the capillary. Additionally, because the capillary itself has a characteristic frequency (resonance frequency) with respect to a transverse vibration, a vibration in a longitudinal direction may occur due to the flexural vibration of the capillary itself.

As mentioned above, if a longitudinal vibration occurs in the vibration of the capillary, it is possible that a fault occurs in the ultrasonic bonding. For example, a phenomenon may happen in which a bonding film (generally, an aluminum film in many cases) formed on a surface of an electrode is extruded into a circumference of a bonded part of a bonding-wire in a bonding part (so-called first bonding) on a primary side of the bonding wire. Such an aluminum film extruded is referred to as a flash. When such a flash occurs, a bonding film directly under the bonded part of the bonding wire is extruded into a circumference. Thus, the bonding film directly under the bonded part of the bonding wire becomes thin, which may result in dissipation of the bonding film in a worst case.

Generation of the flash has been recognized conventionally, and it has been found that a magnitude of generation of the flash differs depending on a combination of a transducer and a capillary. Generation of a flash had not been a large problem before electrode were miniaturized and densified. However, it has been found that generation of a flash gives influences to a bonding strength and bonding reliability. Thus, the inventors studied the cause of generation of a flash, and came to a conclusion that a bonding film is extruded into a circumference of a bonding part due to a longitudinal vibration generated at a tip of a capillary and such an extruded bonding film turns into a flash. That is, the inventor considered that a large cause of generation of a flash lies in not only in the generation of vibration of the capillary in a transverse direction but also in generation of vibration in the capillary in a longitudinal direction and a flexure direction.

Here, as a technique to properly cause a capillary to vibrate in a transverse direction, Japanese Laid-Open Patent Application No. 2009-147185 suggests setting a length of a capillary from an attaching part to a tip of the capillary to a length corresponding to one wavelength (λ) of the vibration of the capillary. Additionally, Japanese Laid-Open Patent Application No. 2010-080519 suggests to set a length of a capillary, when attached to a transducer, to a length corresponding to, for example, a half wavelength (λ/2) of a vibration wavelength of the capillary so that a standing wave is generated in the capillary in which the tip of the capillary becomes an antinode of the vibration.

In a wire-bonding apparatus using an ultrasonic vibration, an extreme end of a transducer at which a capillary is attached is a free end, and a frequency of the ultrasonic vibrator and dimensions of the transducer are set so that the extreme end of the transducer is an antinode of the vibration. It is also preferable that the material and length of the capillary attached to the extreme end of the transducer are set so that the capillary is resonant with the vibration of the transducer.

The capillary is a consumable item, and is used by replacing with new one if necessary. A replacement of the capillary is performed by using a jig for attachment so that an extending length of the capillary from a capillary support part of the transducer is set to a fixed length. Here, the extending length of the capillary is a length of the capillary from a root position at which the capillary is attached to the capillary support part to the tip of the capillary. However, not all of capillaries are made of the same material and have the same dimensions, and there are capillaries having different material characteristics such as Young's modulus, density and Poisson's ratio, and different shapes such as an outer diameter and a size of an aperture to pass a bonding wire therethrough depending on capillary manufacturers. Accordingly, even if the capillary is attached so that the extending length is set to a fixed length, there may be a case where the tip of the capillary vibrates in a longitudinal direction because a flexure vibration is generated in the capillary itself or a flexure vibration is generated in the transducer. If a longitudinal vibration is generated at the tip of the capillary, a flash may be generated in a bonded part of a bonding wire as mentioned above, which may prevent good bonding from being obtained. Thus, it is necessary to accurately adjust a vibration at the tip of the capillary in order to reliably perform wire bonding with high accuracy.

### SUMMARY

There is provided according to an aspect of the invention a capillary configured to be attached to an ultrasonic transducer of a wire-bonding apparatus, the capillary includes: a first part configured to be attached to the ultrasonic transducer; and a second part other than the first part and extending from the first part, wherein the first part has a shape different from a shape of the second part so that the first part has a flexure rigidity larger than the second part.

There is provided according to another aspect of the invention, an ultrasonic transducer used for a wire-bonding apparatus, including: an extreme-end part configured to hold a capillary so that a longitudinal direction of the capillary is perpendicular to a longitudinal direction of the ultrasonic transducer; and fixing concaves provided on an outer surface and arranged opposite to each other in a direction parallel to the longitudinal direction of the capillary.

There is provided according to a further aspect of the invention, a flexure vibration suppressing mechanism to suppress a flexure vibration of an ultrasonic transducer in a wire-bonding apparatus, the flexure vibration suppressing mechanism including: fixing concaves provided on an outer surface of the ultrasonic transducer and arranged opposite to each other in a direction parallel to a longitudinal direction of a capillary attached to an extreme end of the ultrasonic transducer; and fixing pins configured to contact with said ultrasonic transducer by being inserted into said fixing concaves, respectively, to press the ultrasonic transducer.

There is provided according to yet another aspect of the invention an ultrasonic transducer used for a wire-bonding apparatus, wherein an adjustment member is attached to an extreme end of the ultrasonic transducer, the adjustment member configured to suppress a flexure vibration generated in the ultrasonic transducer.

Accordingly, because a flexure vibration of the ultrasonic transducer is suppressed, a vibration of the capillary in the axial direction is suppressed, which permits the capillary to perform the ultrasonic bonding reliably with high accuracy.

The object and advantages of the embodiment will be realized and attained by means of the elements and combinations particularly pointed out in the appended claims.

It is to be understood that both the foregoing general description and the following detailed description are exemplary explanatory only and are not restrictive of the invention, as claimed.

### BRIEF DESCRIPTION OF DRAWINGS

FIGS. 1A and 1B are illustrations of vibration modes of a capillary;
FIGS. 2A and 2B are side views of capillaries having adjusted shapes;
FIGS. 3A and 3B are partially cross-sectioned side views of capillaries having adjusted shapes;
FIGS. 4A and 4B are partially cross-sectioned side view and plan view of a support structure of a transducer in a wire-bonding apparatus;
FIG. 5 is a graph indicating amplitudes of vibration of a transducer along an axial direction;
FIG. 6 is an illustration indicating a concept of a structure of suppressing deformation in a flexure direction of a transducer;
FIG. 7 is a side view of a transducer having a structure of suppressing a flexure vibration in an axial direction of a capillary;
FIG. 8 is a plan view of the transducer illustrated in FIG. 7;
FIG. 9 is a side view of a transducer having a supporter attached thereto; and
FIG. 10 is a side view of another transducer having a supporter attached thereto.

### DESCRIPTION OF EMBODIMENT(S)

Preferred embodiment of the present invention will be explained with reference to the accompanying drawings.

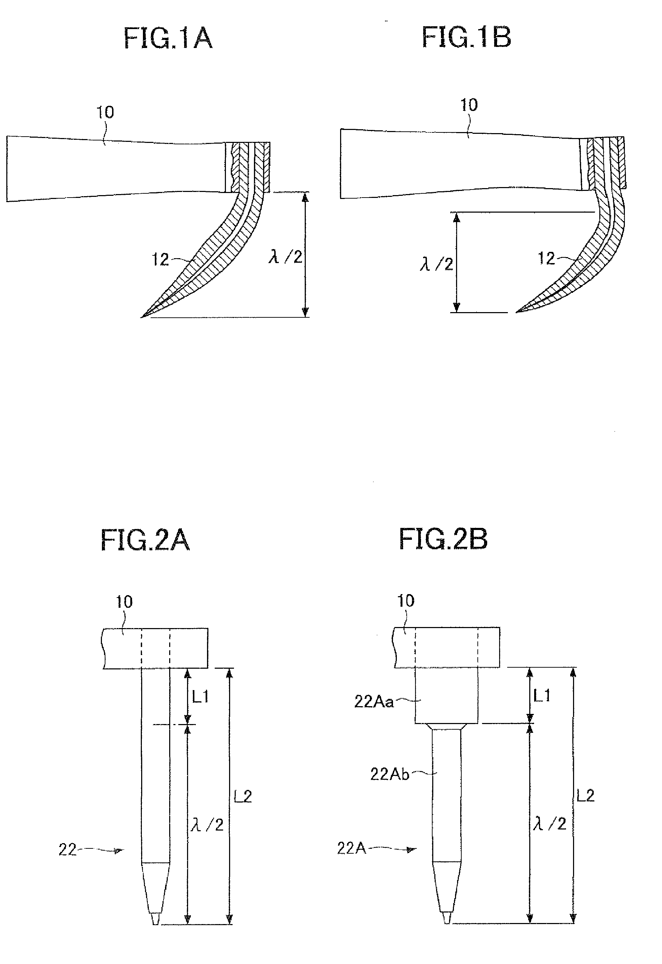

FIGS. 1A and 1B are illustrations of a capillary in a vibrating state. FIG. 1A illustrates a vibration displacement of a capillary 12 having a length L equal to a half (1/2) of a vibration wavelength λ of a resonance frequency of the capillary 12 (L=λ/2). FIG. 2A illustrates a vibration displacement of the capillary 12 having the length L longer than a half (1/2) of a vibration wavelength λ of a resonance frequency of the capillary 12 (L=λ/2). It should be noted that each of FIGS. 1A and 1B illustrates a result of simulation, and the displacement of the capillary 12 is illustrated with exaggeration. Actually, an amplitude of a vibration at a tip of the capillary 12 is nearly equal to an amplitude of a vibration of the transducer 10 at an extreme end thereof, and is equal to, for example, a few nanometers to a few micrometers.

When the capillary 12 is attached to the transducer 10, the length L of the capillary 12 corresponds to a length of a portion of the capillary 12 extending from the transducer 10. The vibration wavelength λ of the capillary 12 is a wavelength at a resonance frequency of a transverse vibration of the capillary 12. As illustrated in FIG. 1A, when the length L of the capillary 12 is equal to the wavelength λ of the capillary 12, a standing wave having antinodes at the tip and the attached part of the capillary 12 and a node at a middle between the tip and the attached art of the capillary 12 is generated in the capillary 12. When such a standing wave is generated in the capillary 12, the capillary 12 is deformed or bowed along a smooth curve extending from the attached part attached to the transducer 10 to the tip of the capillary 12, and, thereby no excessive stress is generated in the capillary 12. It should be noted that also when the length L of the capillary 12 is equal to an integer multiple of a half (1/2) of the wavelength λ of the capillary 12, a standing wave having antinodes at the tip and the attached part of the capillary 12 and a plurality of nodes located in the middle of the capillary 12.

On the other hand, if the length L of the capillary 12 is longer than a half (1/2) of the wavelength λ of the capillary 12 as illustrated in FIG. 1B, the resonance frequency of the capillary 12 is changed. That is, if the length L of the capillary 12 is increased, the resonance frequency is also increased. In such a condition, if the capillary 12 is forcibly vibrated, a standing wave having antinodes at the tip of the capillary 12 and a portion distant from the tip by λ/2 and a node in the middle between the tip and the portion distant from the tip λ/2 is generated in the capillary 12. In this case, a portion of the capillary 12 on the side of the transducer 10 from the portion distant from the tip by λ/2 is bent, and a bending moment is generated in the transducer 10, which causes a flexure vibration in the transducer 10.

If a flexure vibration is generated in the transducer 10, the capillary 12 is vibrated in a flexure vibration mode. Thereby, a vibration in the axial direction (longitudinal vibration) is generated in the capillary 12, which may be a cause of generation of a flash in a bonded part of the bonding wire as mentioned above.

Thus, according to a first embodiment, the resonance frequency of the capillary 12 is adjusted by adjusting a shape of the capillary 12 in order to suppress a flexure vibration of the transducer 10.

FIGS. 2A and 2B are views illustrating adjustment of the shape of a capillary. FIG. 2A is a side view of a capillary 22 before a shape adjustment is applied. FIG. 2B is a side view of a capillary 22A after the shape adjustment is applied. The capillary 22 before shape adjustment has an elongated cylindrical shape having a tapered tip. A length L2 of the capillary 22 is longer than the half wavelength λ/2 of a resonance frequency of a transverse vibration of the capillary 22 by a length L1.

Here, when an ultrasonic vibration is transmitted to the transducer 10 to cause the capillary 22 to generate a transverse vibration, a vibration mode is set as illustrated in FIG. 1B, which generates a flexure vibration in the transducer 10. Thus, the shape of the capillary 22 is adjusted to form the capillary 22A by providing a large diameter part 22Aa in a base part, which is a root of the capillary 22A, as illustrated in FIG. 2B. Because a length of the large diameter part 22Aa is set to the length L1, a length of a small diameter part 22Ab of the capillary 22A other than the large diameter part 22Aa and extending from the large diameter part 22Aa is set to λ/2. In other words, the capillary 22A is formed by enlarging a portion of the capillary 22 exceeding the length λ/2 of the capillary 22.

The large diameter part 22Aa has a wall thickness larger than that of the small diameter part 22Ab by a difference in outer diameter. That is, the large diameter part 22Aa of the capillary 22A has a flexure rigidity larger than that of the small diameter part 22Ab and is less deformable. Thereby, a portion of the capillary 22A, which portion vibrates in a flexure vibration mode, corresponds to a portion, which is substantially the small diameter part 22Ab, other than the large diameter part 22Aa. Accordingly, when an ultrasonic vibration is transmitted to the transducer 10 to cause the capillary 22A to vibrate in a transverse vibration mode, the large diameter part 22Aa, which is the base part of the capillary 22A, vibrates as if it is a part of the transducer 10, and, thereby, a flexure vibration is generated in only the small diameter part 22Ab. This state as a vibration system corresponds to the vibration system illustrated in FIG. 1A, and a flexure vibration generated in the transducer 10 is suppressed.

Although the length of the small diameter part 22Ab is set to λ/2 in the above-mentioned example, the length of the small diameter part 22Ab, in which a flexure vibration is generated, may be set to an integer multiple of λ/2 (Nλ/2: N is a natural number).

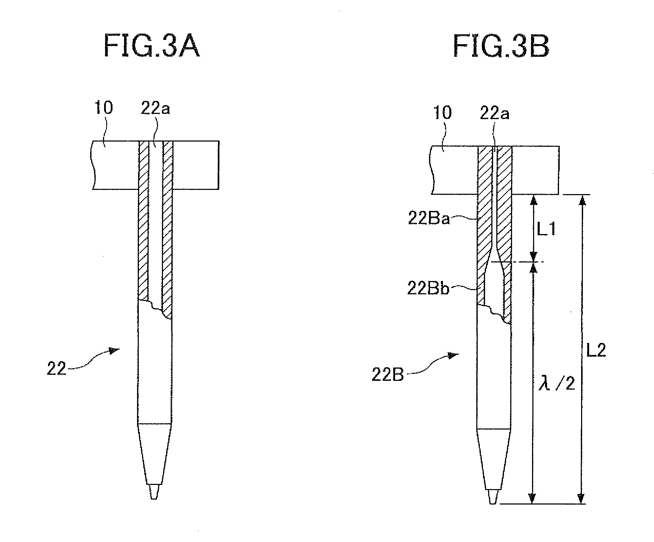

FIGS. 3A and 3B are views illustrating another adjustment of the shape of a capillary. FIG. 3A is a side view of a capillary 22 before a shape adjustment is applied. FIG. 3B is a side view of a capillary 22B after the shape adjustment is applied. The capillary 22 before shape adjustment has an elongated cylindrical shape having a tapered tip. A length L2 of the capillary 22 is longer than the half wavelength λ/2 of a resonance frequency of a transverse vibration of the capillary 22 by a length L1.

Here, when an ultrasonic vibration is transmitted to the transducer 10 to cause the capillary 22 to generate a transverse vibration, a vibration mode is set as illustrated in FIG. 1B, which generates a flexure vibration in the transducer 10. Thus, the shape of the capillary 22 is adjusted to form the capillary 22B by providing a thick wall part 22Ba in a base part, which is a root of the capillary 22B, by reducing an inner diameter of a through hole 22a as illustrated in FIG. 3B. Because a length of the thick wall part 22Ba is set to the length L1, a length of a thin wall part 22Bb of the capillary 22B other than the thick wall part 22Ba and extending from the thick wall part 22Ba is set to λ/2. In other words, the capillary 22B is formed by reducing the inner diameter of the through hole 22a in a portion of the capillary 22 exceeding the length λ/2 of the capillary 22.

The thick wall part 22Ba has a wall thickness larger than that of the thin wall part 22Bb by a difference in inner diameter of the through hole 22a. That is, the thick wall part 22Ba of the capillary 22B has a flexure rigidity larger than that of the thin wall part 22Bb and is less deformable. Thereby, a portion of the capillary 22B, which portion vibrates in a flexure vibration mode, corresponds to a portion, which is substantially the thin wall part 22Bb, other than the thick wall part 22Ba. Accordingly, when an ultrasonic vibration is transmitted to the transducer 10 to cause the capillary 22B to vibrate in a transverse vibration mode, the thick wall part 22Ba, which is the base part of the capillary 22B, vibrates as if it is a part of the transducer 10, and, thereby, a flexure vibration is generated in only the thin wall part 22Bb. This state as a vibration system corresponds to the vibration system illustrated in FIG. 1A, and a flexure vibration generated in the transducer 10 is suppressed.

Although the length of the thin wall part 22Bb is set to λ/2 in the above-mentioned example, the length of the small diameter part 22Bb, in which a flexure vibration is generated, may be set to an integer multiple of λ/2 (Nλ/2: N is a natural number).

Next, a description will be given of a second embodiment. In the second embodiment, a pressing force is applied to a transducer to forcibly reduce a flexure vibration of the transducer.

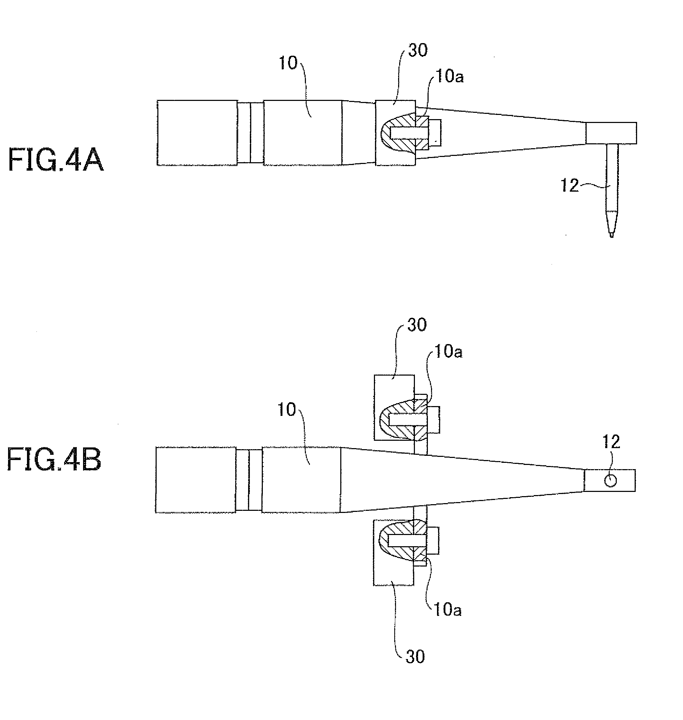

FIGS. 4A and 4B are views illustrating a support structure of the transducer 10 in the wire-bonding apparatus. FIG. 4A is a side view of a bonding head, and FIG. 4B is a plan view of the bonding head. The transducer 10 has a flange 10a, which extends to right and left from a portion corresponding to a node of an ultrasonic vibration. The transducer 10 is fixed to the apparatus by fixing the flange 10a to a fixing block 30 of the apparatus side by screws.

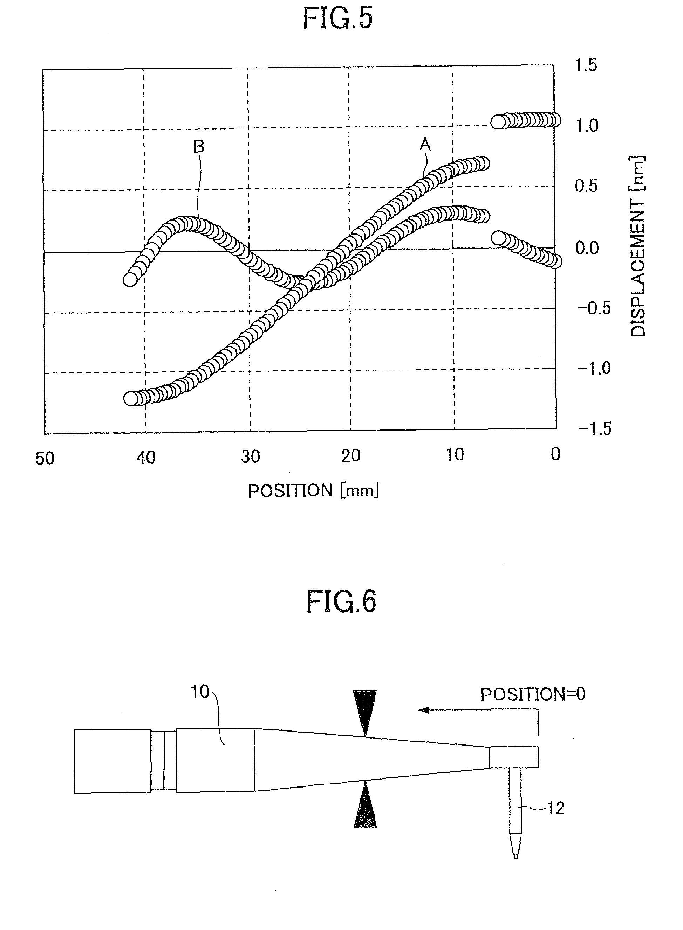

A description is given below, with reference to FIG. 5, of a vibration displacement of the transducer 10. FIG. 5 is a graph illustrating amplitudes of vibration of the transducer 10 along an axial direction of the transducer 10. The horizontal axis of the graph of FIG. 5 represents a position in an axial direction of the transducer 10, and the extreme end of the transducer 10 is indicated as a start point at 0 mm. The vertical axis represents a displacement (corresponding to an amplitude) of the transducer. In FIG. 5, a line indicated by A illustrates an amplitude (an amplitude of a longitudinal vibration) in the axial direction (longitudinal direction) of the transducer 10, which is an ultrasonic vibration for vibrating the capillary 12. In FIG. 5, a line indicated by B illustrates a displacement (an amplitude of a flexure vibration) in a direction perpendicular to the axial direction of the transducer 10, which direction corresponds to the axial direction of the capillary 12.

The example illustrated in FIG. 5 is a result of simulation in a case where the transducer 10 including the vibrator has a total length of about 40 mm. The displacement in the axial direction (amplitude of a longitudinal vibration) indicated by A is zero at the middle (near 20 mm) of the transducer 10. This is because the transducer 10 is designed so that opposite ends of the transducer 10 become antinodes of a vibration (portions of which amplitude is maximum). The fixing part of the transducer 10 corresponds to the position of a node, which is in the middle between the opposite ends (20 mm from each end).

On the other hand, a displacement in the axial direction of the capillary 12 indicated by B (an amplitude of a flexure vibration) varies complexly along the axial direction of the transducer 10. In the middle part in which the fixing part of the transducer 10 is provided, the amplitude of the flexure vibration is not zero but an amplitude having a certain magnitude.

Here, as illustrated in FIG. 6, a flexure vibration of the transducer 10 can be suppressed by fixing a portion of the transducer 10 to suppress a flexure deformation of the transducer 10. However, when fixing the transducer 10 in a direction of flexure to suppress a flexure vibration of the transducer 10, it is possible that a longitudinal vibration of the transducer 10 (the line A of FIG. 5) is also suppressed. Thus, according to the present embodiment, only a flexure vibration is suppressed without suppressing a longitudinal vibration by fixing the portion corresponding to a node of the longitudinal vibration (that is, a portion at which an amplitude of the longitudinal vibration is zero) of the transducer 10 in the axial direction of the capillary 12. Originally, the portion of the transducer fixed to the apparatus side is provided in a portion corresponding to a node of the longitudinal vibration of the transducer 10 as illustrated in FIGS. 4A and 4B. Thus, a flexure vibration of the transducer 10 in the axial direction of the capillary 12 can be suppressed without suppressing a longitudinal vibration by fixing the transducer 10 in the axial direction of the capillary 12 at a portion to fix the transducer 10 to the apparatus side.

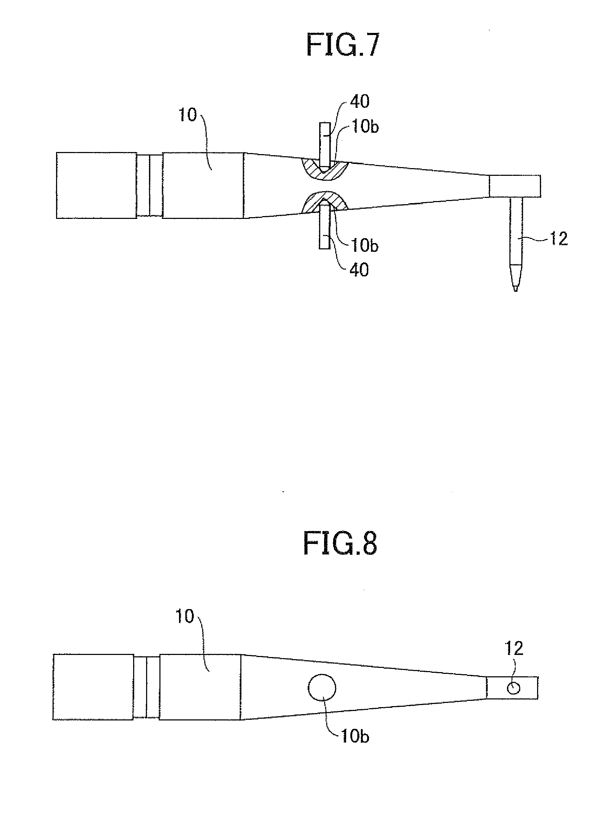

FIG. 7 is a side view of a transducer having a structure of suppressing a flexure vibration in the axial direction of the capillary 12. FIG. 8 is a plan view of the transducer illustrated in FIG. 7. The structure of suppressing a flexure vibration of the transducer 10 includes fixing concavities 10b, which are provided in the middle part between opposite ends of the transducer 10 in the axial direction, and fixing pins 40 inserted into the fixing concavities 10, respectively. The fixing concavities 10b are provided on opposite sides (upper and lower sides in FIG. 7) of the transducer 10 in the axial direction of the capillary 12. The fixing pins 40 are inserted into the respective fixing concavities 10b from both sides in the axial direction of the capillary 12, and are brought into contact with and pressed against bottom portions of the concavities 30b, respectively. Accordingly, because the transducer 10 is fixed by being clamped by the fixing pins 40, a flexure deformation (flexure vibration) of the transducer 10 in the axial direction of the capillary 12 is suppressed. As mentioned above, a flexure vibration suppressing mechanism is formed by the two fixing concavities 10b provided on the outer circumferential surface of the transducer 10 and two fixing pins 40 being brought into contact with and pressing against the transducer 10 in a state where the fixing pins 40 are inserted into the fixing concavities 10b.

The fixing concavities 10b are provided in a portion corresponding to a node of a vibration in the axial direction of the transducer 10, and are arranged at positions different from the flange 10a for fixing the transducer 10 by 90 degrees. Accordingly, even if there is the structure of fixing transducer 10, the flexure vibration suppressing mechanism to suppress a flexure vibration of the transducer 10 can be provided easily.

It should be noted that although the positions of forming the concavities 10b are distant from the extreme end of the transducer 10 by λ/2, the fixing concavities 10b can be formed at positions corresponding to a node of a longitudinal vibration and may be a position distant from the extreme end by an integer multiple of λ/2 (Nλ/2: N is a natural number).

A description will be given of a third embodiment. In the third embodiment, a flexure vibration of the transducer 10 is suppressed by attaching a supporter as an adjustment member at the extreme end of the transducer 10.

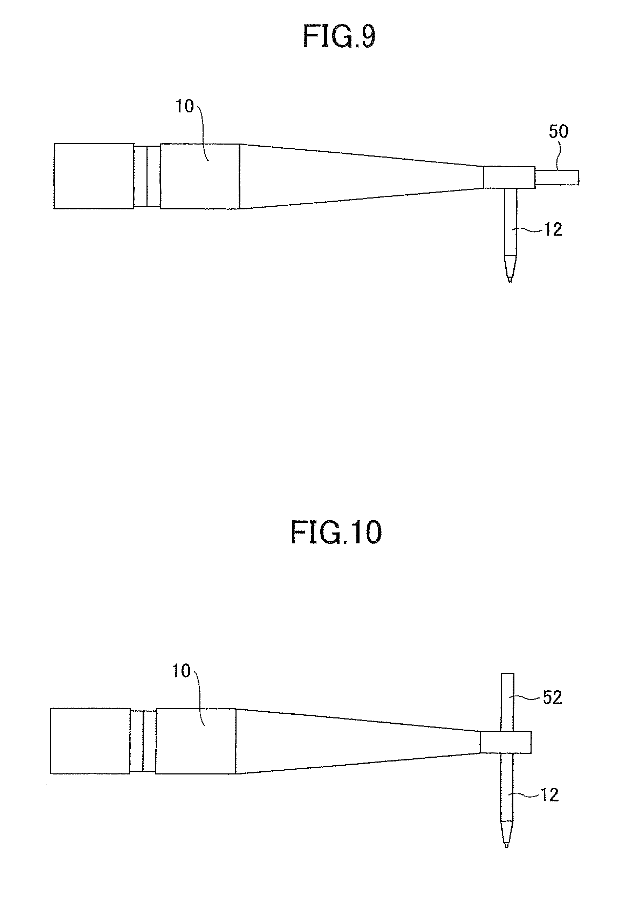

FIG. 9 is a side view illustrating an example of the transducer 10 having a supporter attached thereto. The supporter 50 illustrated in FIG. 9 is a member having an elongated shape, and is attached to the extreme end of the transducer 10 to extend along the axial direction (longitudinal direction) of the transducer 10. By attaching the supporter 50 at the extreme end of the transducer 10, the resonance frequency of the transducer 10 can be adjusted. For example, if the position of attaching the capillary 12 is offset from a position corresponding to an antinode of a longitudinal vibration of the transducer 10, a flexure vibration is generated in the transducer 10 due to attachment of the capillary 12. Thus, an adjustment is made so that the position of attaching the capillary 12 matches an antinode of the longitudinal vibration of the transducer 10 by attaching the supporter 50 to the transducer 10 to vary the resonance frequency of the transducer 10. Thereby, a flexure vibration of the transducer 10 can be suppressed.

FIG. 10 is a side view illustrating another example of the transducer 10 having a supporter attached thereto. The supporter 52 illustrated in FIG. 10 is a member having an elongated shape, and is attached to the extreme end of the transducer 10 on a side opposite to the capillary 12 and to extend in an axial direction of the capillary 12. By attaching the supporter 52 at the extreme end of the transducer 10, asymmetricity of the vibration system caused by the capillary 12 attached to the transducer 10 is eliminated, which allows the vibration system to be configured in a symmetric form. Accordingly, a flexure vibration caused by asymmetricity due to attachment of the capillary 12 can be suppressed.

## Claims

1. A capillary configured to be attached to an ultrasonic transducer of a wire-bonding apparatus, said capillary comprising:
a first part configured to be attached to said ultrasonic transducer; and
a second part other than said first part and extending from said first part,
wherein said first part has a shape different from a shape of said second part so that said first part has a flexure rigidity larger than said second part.

2. A capillary as claimed in claim 1, wherein said first part has an outer diameter larger than an outer diameter of said second part.

3. A capillary as claimed in claim 1, wherein a through hole penetrates through said first part and said second part, and an inner diameter of said through hole in said first part is smaller than an inner diameter of said through hole in said second part.

4. An ultrasonic transducer used for a wire-bonding apparatus, comprising:
an extreme-end part configured to hold a capillary so that a longitudinal direction of said capillary is perpendicular to a longitudinal direction of said ultrasonic transducer; and
fixing concaves provided on an outer surface and arranged opposite to each other in a direction parallel to the longitudinal direction of said capillary.

5. The ultrasonic transducer as claimed in claim 4, wherein said fixing concaves are provided at a position corresponding to a node of a longitudinal vibration generated in said ultrasonic transducer.

6. A flexure vibration suppressing mechanism to suppress a flexure vibration of an ultrasonic transducer in a wire-bonding apparatus, said flexure vibration suppressing mechanism comprising:
fixing concaves provided on an outer surface of said ultrasonic transducer and arranged opposite to each other in a direction parallel to a longitudinal direction of a capillary attached to an extreme end of said ultrasonic transducer; and
fixing pins configured to contact with said ultrasonic transducer by being inserted into said fixing concaves to press said ultrasonic transducer.

7. The flexure vibration suppressing mechanism as claimed in claim 6, wherein said fixing concaves are provided at a position corresponding to a node of a longitudinal vibration generated in said ultrasonic transducer.

8. An ultrasonic transducer used for a wire-bonding apparatus, wherein an adjustment member is attached to an extreme end of said ultrasonic transducer, the adjustment member configured to suppress a flexure vibration generated in said ultrasonic transducer.

9. The ultrasonic transducer as claimed in claim 8, wherein said adjustment member is an elongated member extending from an extreme end of said ultrasonic transducer in a longitudinal direction of said ultrasonic transducer.

10. The ultrasonic transducer as claimed in claim 8, wherein said adjustment member is an elongated member extending on a side opposite to a capillary attached to en extreme end of said ultrasonic transducer in a direction of a longitudinal direction of said capillary.
